# EUROPEAN PATENT SPECIFICATION

(11) **EP 0 479 599 B1**
(45) Date of publication and mention of the grant of the patent: **11.12.1996**
(21) Application number: 91309100.5
(22) Date of filing: 04.10.1991
(51) Int. Cl.: H04M 1/72, H03L 7/18

(54) **Method and apparatus for controlling switches**
Verfahren und Vorrichtung zur Steuerung von Schaltern
Méthode et appareil pour la commande d'interrupteurs

(30) Priority: 05.10.1990 FI 904924
(43) Date of publication of application: 08.04.1992
(73) Proprietor: NOKIA MOBILE PHONES LTD., 24101 Salo (FI)
(72) Inventor: Liukkonen, Jorma, SF-24100 Salo (FI)
(74) Representative: Cross, Rupert Edward Blount

(56) References cited:
- EP-A- 0 220 700
- US-A- 3 566 275
- ELECTRONIC COMPONENTS AND APPLICATIONS vol. 9, no. 2, 31 December 1989, Eindhoven, NL, pp. 66-89; WIM ROSINK: 'ALL-DIGITAL PHASE-LOCKED LOOPS USING THE 74HC/HCT297'
- PATENT ABSTRACTS OF JAPAN vol. 3, no. 107 (E-136) 8 September 1979 & JP-A-54 84 451

## Description

The present invention relates to a method and apparatus for controlling on/off type switches of the RF part of a radio telephone, without having to draw separate control lines from the logic unit of the telephone to the switches.

The radio part of any modern radio telephone comprises a plurality of controlled switches with which a given electrical circuit can be switched to be active or off, or its parameters can be changed. Said switches are two-position switches, normally bipolar transistors of FETs, and they control, for instance, switchable filters or regulators of the transmitter. Said switches are in turn controlled by the logic unit (processor) of the radio telephone, i.e. a lead, over which a logic "1" or "0", i.e. voltage "high" or "low" is carried to the base of the transistor of FET serving as switch. The logic unit also controls the frequency synthesisers by which the local oscillator frequencies of the transmitter and receiver are produced. As is known in the art, the frequency synthesizer comprises a phase-locked loop (PLL) comprising a phase comparator, a voltage controlled oscillator (VCO), and a programmable divider, dividing the initial frequency of the VCO prior to its being carried to the second input of the phase comparator. The initial frequency of the loop is determined by the above-mentioned programmable divider. The logic unit sets the frequency synthesiser to the desired channel by changing, over a control line, the division number of the divider to be consistent with the desired channel. Most usually there are three control lines: by one of said lines the division number is supplied in binary serial form to the register of the phase-locked loop, by a second line a timing signal (clock pulse) is sent, and by the third line, an enable pulse, which on arrival in the phase-locked loop causes the loop-division number supplied to the register to be transmitted from the registers of the loop circuit to become the contents of the counters.

Also such frequency synthesiser components implemented using one integrated circuit are known in the art in which the control word used for channel change sets certain connecting pins of the circuit to "one" or "zero" state. From said pins, control may be derived for external controlled switches. In said circuits the decoding logic required for implementing the function is integrated into the PLL circuit.

The switch control line methods of prior art are encumbered by some drawbacks. As mentioned above, each controlled switch in the radio unit requires an individual control line from the processor, although in certain instances one control line is able to control a number of switches. Therefore, the more control lines are needed the greater the number of controlled switches in the circuit. This is experienced as an inconvenience when designing a circuit board. If the switches to be controlled and the processor are mounted on separate circuit boards, a multiple pin connector is needed to transfer the control signals from one board to another. If the connecting pins of the PLL circuit are utilised in the control, the number of the pins must be increased, and this leads to larger physical bulk. This is a nuisance in developing telephones of smaller size. Furthermore, it may be noted that PLL components of this type appropriate for portable telephone applications are hard to find.

The present invention discloses a way in which control of switches can be implemented without the above drawbacks.

The present invention provides apparatus for controlling a switch in the radio frequency part of a radio telephone, comprising a logic unit, a frequency synthesiser, at least one control line (a,b,c,) connected to said frequency synthesiser for transmitting control signals from said logic unit to said frequency synthesiser, a switch line (d,e,) for controlling said switch in response to a control voltage supplied by said logic unit, characterised in that said switch line (d,e) is connected to a control line (a,b) such that during the time when said frequency synthesiser is not receiving control signals, the logic unit provides a control voltage over said control line (a,b) and said switch line (d,e) to control said switch.

Preferably, the apparatus includes a low pass filter provided in said switch line (d,e) to inhibit the passage of said control signals to said switch.

In a further preferred embodiment at least two switch lines (d,e) are connected to respective control lines (a,b), no switch line being connected to the control line (c) that transmits the enable pulse from the logic unit.

In another preferred embodiment attenuation resistors are connected to the control lines at their input to the frequency synthesiser to attenuate said control voltage.

The processor of the radio telephone may, during the rest of the time, use the control lines of the PLL circuit as control lines for on/off control of the switches in the RF unit, since the control lines of the phase-locked loop are active only for the time needed in feeding the division number to the registers of the loop circuit, i.e. about millisecond. During that time when the PLL circuit receives no external control, i.e. while no new division number is being supplied, its control lines are in zero state, and the state of the clock and data lines can then be changed without affecting the operation of the PLL circuit in any way. The state of the line by which the enable pulse is supplied must not be changed because it effects a change in the starting frequency of the loop. Therefore, the clock and data lines can indeed be used for controlling the switches. If a plurality of synthesisers are used in the RF unit of the telephone, the control lines of all these are available for controlling the switches.

One embodiment of the invention is described in more detail referring to the accompanying schematic drawing.

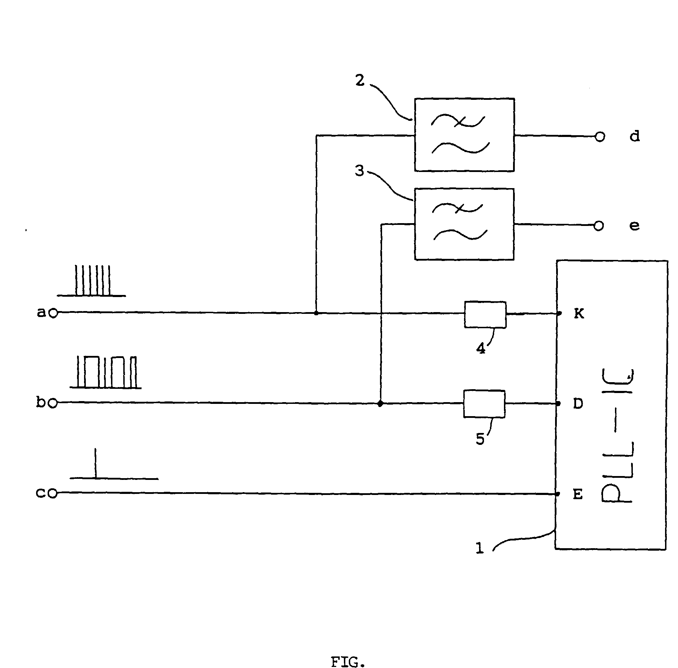

Reference numeral 1 refers to a phase-locked loop. A phase-locked loop in its entirety, or parts thereof, most usually the phase comparator and the dividers, are integrated in one chip. The connecting pin K of the circuit receives from the control logic (not shown) timing pulses by the line a, the connecting pin D receives the division number of the loop divider in binary serial form by the line b, and by the line c the enable pulse arrives at the connecting pin E. When the starting frequency of the PLL ciruit is going to be changed, the processor transmits on lines a and b a binary word indicating the clock pulses and the division number. Thereafter, the processor transmits a sharp enable pulse on line c, resulting in the division number within the PLL circuit transferring from the registers to the counter. After the loop has locked onto the selected frequency, the lines a, b and c are in "zero" state. During this time the control voltage for the switches can be transmitted from the processor by the lines a and b, and further by the switch line d connected to the line a, and by the switch line e connected to the line b, to the switches being controlled (not shown), their control thus taking place simply by setting the channel control line and/or clock line of the PLL, as implied by the need of control, to state one or zero. The control voltage can be low frequency compared to the pulses and hence the disturbance caused in the switch lines d and e, by the feeding of division number, is attenuated by means of a low pass filter 2 and 3 included in each line; these filters may be simple RC filters. Hereby, the voltage on lines d and e cannot ascend to such height during the feeding of division numbers that it would cause a change in the state of the switches. The resistors 4 and 5 in the inputs of pins K and D of circuit 1 serve as attenuation resistors. The voltage shapes of the lines are also outlined in the figure.

Using this arrangement, the use of extra switch control lines can be avoided, and it is not necessary to use any such PLL component containing extra logic on the pins of which the control voltage for the switches could be obtained. The lines to the switches can be connected at any point of the control lines. In the connector which may be needed at the interface of the RF part and the logic unit no pins need to be provided for the switch control, hence a smaller connector can be used. The arrangement disclosed hereinabove is simple and inexpensive in implementation.

## Claims

1. Apparatus for controlling a switch in the radio frequency part of a radio telephone, comprising a logic unit, a frequency synthesiser (1), at least one control line (a,b,c,) connected to said frequency synthesiser (1) for transmitting control signals from said logic unit to said frequency synthesiser (1), a switch line (d,e,) for controlling said switch in response to a control voltage supplied by said logic unit, characterised in that said switch line (d,e) is connected to a control line (a,b) such that during the time when said frequency synthesiser (1) is not receiving control signals, the logic unit provides a control voltage over said control line (a,b) and said switch line (d,e) to control said switch.

2. Apparatus as claimed in Claim 1 further including a low pass filter (2,3) provided in said switch line (d,e) to inhibit the passage of said control signals to said switch.

3. Apparatus as claimed in either Claim 1 or Claim 2, wherein at least two switch line (d,e) are connected to respective control lines (a,b), no switch line being connected to the control line (c) that transmits an enable pulse from the logic unit.

4. Apparatus as claimed in any preceding claim, including attenuation resistors connected to the control lines at their input to the frequency synthesiser (1) to attenuate said control voltage.

5. A method of controlling a switch in the radio frequency part of a radio telephone, comprising the steps of transmitting control signals from a logic unit to a frequency synthesiser (1) over at least one control line (a,b,c,), and transmitting a control voltage to a switch over a switch line (d,e) characterised in that said switch line (d,e) is connected to a control line (a,b) and during the time when said frequency synthesiser (1) is not receiving control signals, the logic unit provides a control voltage over said control line (a,b) and said switch line (d,e) to control said switch.

6. A method as claimed in claim 5, wherein said control signals from said logic unit are attenuated in said switch line using a low pass filter.

7. A method as claimed in either of Claims 5 or 6, wherein the control voltage is attenuated by attenuation resistors in the control lines (a,b) at their input to the frequency synthesiser (1).

## Patentansprüche

1. Vorrichtung zur Steuerung eines Schalters im Funkfrequenzteil eines Funktelefons, enthaltend: eine Logikeinheit. einen Frequenzsynthesizer (1), wenigstens eine Steuerleitung (a. b, c), die mit dem Frequenzsynthesizer (1) verbunden ist, um Steuersignale von der Logikeinheit zum Frequenzsynthesizer (1) zu übertragen, und eine Schaltungsleitung (d, e) zur Steuerung des Schalters in Antwort auf eine Steuerspannung, die von der Logikeinheit geliefert wird, **dadurch gekennzeichnet,** daß die Schaltungsleitung (d. e) mit einer Steuerleitung (a, b) derart verbunden ist, daß während der Zeit, in der der Frequenzsynthesizer (1) keine Steuersignale empfängt, die Logikeinheit eine Steuerspannung über die Steuerleitung (a, b) und die Schaltungsleitung (d, e) zur Steuerung des Schalters liefert.

2. Vorrichtung nach Anspruch 1, **gekennzeichnet durch** einen Tiefpassfilter (2, 3) in der Schaltungsleitung (d, e), um einen Durchgang der Steuersignale zum Schalter zu verhindern.

3. Vorrichtung nach Anspruch 1 oder 2, **gekennzeichnet durch** wenigstens zwei Schaltungsleitungen (d, e), die mit jeweiligen Steuerleitungen (a, b) verbunden sind, wobei keine Schaltungsleitung mit der Steuerleitung (c) verbunden ist. die einen Startpuls von der Logikeinheit überträgt.

4. Vorrichtung nach irgendeinem der vorhergehenden Ansprüche, **gekennzeichnet durch** Dämpfungswiderstände, die mit den Steuerleitungen an deren Eingang zum Frequenzsynthesizer (1) verbunden sind, um die Steuerspannung zu dämpfen.

5. Verfahren zur Steuerung eines Schalters im Funkfrequenzteil eines Funktelefons, mit folgenden Schritten: Aussenden von Steuersignalen von einer Logikeinheit zu einem Frequenzsynthesizer (1) über wenigstens eine Steuerleitung (a, b, c), und Übertragung einer Steuerspannung zu einem Schalter über eine Schaltungsleitung (d, e), **dadurch gekennzeichnet**, daß die Schaltungsleitung (d. e) mit einer Steuerleitung (a, b) verbunden ist, und daß in der Zeit, in der der Frequenzsynthesizer (1) keine Steuersignale empfängt, die Logikeinheit eine Steuerspannung über die Steuerleitung (a, b) und die Schaltungsleitung (d, e) zur Steuerung des Schalters liefert.

6. Verfahren nach Anspruch 5, **dadurch gekennzeichnet**, daß die Steuersignale von der Logikeinheit in der Schaltungsleitung unter Verwendung eines Tiefpassfilters gedämpft werden.

7. Verfahren nach Anspruch 5 oder 6, **dadurch gekennzeichnet**, daß die Steuerspannung durch Dämpfungswiderstände in den Steuerleitungen (a, b) gedämpft wird, die an den Eingängen der Steuerleitungen zum Frequenzsynthesizer (1) liegen.

## Revendications

1. Appareil pour commander un commutateur dans la partie haute fréquence d'un radiotéléphone, comprenant une unité logique, un synthétiseur de fréquence (1), au moins une ligne de commande (a, b, c,) connectée audit synthétiseur de fréquence (1) afin de transmettre des signaux de commande à partir de l'unité logique audit synthétiseur de fréquence (1), une ligne de commutateur (d, e,) pour commander ledit commutateur en réponse à une tension de commande fournie par ladite unité logique, caractérisé en ce que ladite ligne de commutateur (d, e) est connectée à une ligne de commande (a, b) de façon que pendant le laps de temps au cours duqel ledit synthétiseur de fréquence (1) ne reçoit aucun signal de commande, l'unité logique fournit une tension de commande par ladite ligne de commande (a, b) et ladite ligne de commutateur (d, e) afin de commander ledit commutateur.

2. Appareil selon la revendication 1 comprenant en outre un filtre passe-bas (2, 3) fourni dans ladite ligne de commutateur (d, e) pour inhiber le passage desdits signaux de commande vers ledit commutateur.

3. Appareil selon l'une ou l'autre de la revendication 1 ou de la revendication 2, dans lequel au moins deux lignes de commutateur (d, e) sont connectées à des lignes de commande respectives (a, b), aucune ligne de commutateur n'étant reliée à la ligne de commande (c) qui transmet une impulsion de validation à partir de l'unité logique.

4. Appareil selon l'une quelconque des revendications précédentes, comprenant des résistances d'atténuation reliées aux lignes de commande à leur entrée dans le synthétiseur de fréquence (1) afin d'atténuer ladite tension de commande.

5. Procédé pour commander un commutateur dans la partie haute fréquence d'un radiotéléphone, comprenant les étapes consistant à transmettre des signaux de commande à partir d'une unité logique à un synthétiseur de fréquence (1) par au moins une ligne de commande (a, b, c,), et à transmettre une tension de commande à un commutateur par une ligne de commutateur (d, e), caractérisé en ce que ladite ligne de commutateur (d, e) est reliée à une ligne de commande (a, b) et pendant le laps de temps au cours duquel ledit synthétiseur de fréquence (1) ne reçoit aucun signal de commande, l'unité logique fournit une tension de commande par ladite ligne de commande (a, b) et ladite ligne de commutateur (d, e) pour commander ledit commutateur.

6. Procédé selon la revendication 5, dans lequel lesdits signaux de commande provenant de ladite unité logique sont atténués dans ladite ligne de commutateur en utilisant un filtre passe-bas.

7. Procédé selon l'une ou l'autre des revendications 5 ou 6, dans lequel la tension de commande est atténuée par des résistances d'atténuation dans les lignes de commande (a, b) à leur entrée dans le synthétiseur de fréquence (1).
